# FASCICULE DE BREVET EUROPEEN

(11) **EP 0 811 269 B1**
(45) Date de publication et mention de la délivrance du brevet: **14.02.2001**
(21) Numéro de dépôt: 96940681.8
(22) Date de dépôt: 29.11.1996
(51) Int. Cl.: H02K 37/14

(54) **MOTEUR DIPHASE, NOTAMMENT UN MOTEUR D'HORLOGERIE OU UN MOTEUR POUR L'ENTRAINEMENT D'UNE AIGUILLE D'UN AFFICHEUR**
ZWEIPHASENMOTOR,INSBESONDERE FÜR ZEITMESSGERÄT ODER ZUM ANTRIEB EINES ZEIGERS EINER ANZEIGE
TWO-PHASE MOTOR, PARTICULARLY A TIME PIECE MOTOR OR A MOTOR FOR DRIVING THE HAND OF A DISPLAY

(30) Priorité: 22.12.1995 FR 9515438
(43) Date de publication de la demande: 10.12.1997
(73) Titulaire: Sonceboz S.A., 2605 Sonceboz (CH)
(72) Inventeur: PRUDHAM, Daniel, F-25220 Thise (FR)
(74) Mandataire: Ayache, Monique
(86) Numéro de dépôt international: FR9601904
(87) Numéro de publication internationale: WO9723943

(56) Documents cités:
- WO-A-92/22122
- FR-A- 2 201 575
- GB-A- 199 424
- NL-A- 7 308 770

## Description

La présente invention concerne un moteur électrique diphasé, notamment un moteur d'horlogerie ou un moteur pour l'entraînement d'une aiguille d'un afficheur.

De tels moteurs sont par exemple décrits dans le brevet européen EP587685 de la demanderesse. Un moteur selon le préambule de la revendication 1 est décrit dans FR 2.201.575. Le but de l'invention est d'améliorer de tels moteurs de façon à augmenter le couple et à éliminer la pièce de fermeture de flux sans perdre l'avantage de la simplicité de la fabrication et les possibilités d'intégration des mécanismes associés tels les réducteurs.

A cet effet, l'invention concerne un moteur diphasé selon la revendication 1 formé par une partie statorique excitée par des bobines électriques et par un rotor aimanté présentant N paires de pôles aimantés radialement en sens alternés, N étant égal à 3 ou à 5. La partie statorique présente au moins deux circuits en forme de W comportant chacun une bobine électrique entourant la jambe centrale. Les circuits en W sont disposés de façon à ce que lorsque l'une des jambes centrales se trouve en face d'une transition magnétique, l'autre jambe centrale se trouve en face d'un pôle magnétique. Les épanouissements polaires des jambes d'un circuit en W étant espacés angulairement de π/4 et les épanouissements polaires des jambes centrales de deux circuits en W appartenant à des phases différentes étant écartés angulairement d'un angle sensiblement égal à π/2±k.π/N, où N est le nombre de paires de pôles magnétiques, soit 3 ou 5 et k est égal à 0, 1, ou 2.

Un tel moteur répond aux objectifs de l'invention grâce à un nombre accru de dents actives et grâce à une réduction du trajet des lignes de champ dans l'air. La forme du circuit statorique en "W" assure la fermeture des lignes de champ entre le pôle central qui reçoit la bobine et les deux pôles adjacents.

Avantageusement, les deux circuits en "W" présentent une jambe commune. Le stator peut ainsi être réalisé sous forme d'une seule pièce, ce qui élimine tout problème de positionnement angulaire que l'on rencontre avec des stators formés de plusieurs pièces fixées sur un support.

Dans un mode de réalisation préférée, l'invention concerne un moteur de faible coût d'assemblage et de très faible épaisseur.

Selon une première variante, les jambes extérieures des deux circuits en "W" sont reliés par un pontet en forme d'arc de cercle, le pontet présentant avantageusement des dents statoriques écartées de π/4 degrés. Cette variante permet de réaliser un moteur avec un nombre réduit de composant, à savoir un rotor, un stator formé par une seule pièce supportant deux bobines électriques seulement.

Les moteurs pas-à-pas selon l'état de la technique présentent par ailleurs un déplacement saccadé, dû au fait qu'un pôle aimanté du rotor trouve une position d'équilibre privilégié lorsqu'il est placé en regard d'une dent statorique, ou lorsqu'une transition entre deux pôles magnétiques se trouve en regard d'une dent statorique. Le couple de détente constitue de ce fait une fonction périodique de la position angulaire dont la fréquence dépend du nombre de pôles magnétique et du nombre de pôles statoriques. On a cherché dans l'état de la technique à "lisser" cette fonction en augmentant le nombre de pôles. Cela implique toutefois une plus grande complexité mécanique et un coût de fabrication et d'assemblage élevé.

Un deuxième but de la présente invention est de remédier à cet inconvénient en proposant une construction offrant, avec un nombre de pôles magnétiques et statorique raisonnable, une limitation sensible du couple de détente.

A cet effet, l'invention concerne un mode de réalisation préféré mettant en oeuvre quatre circuits en "W" dont les jambes adjacentes sont communes et forment ainsi un stator à 8 pôles. Les jambes centrales des circuits en "W" diamétralement opposés portent des bobines de la même phase.

Cette structure permet de réduire considérablement le couple de détente par annulation des harmoniques 2 et 4 de la fonction (couple de détente, position angulaire). Le moteur selon l'invention présente ainsi un déplacement non saccadé malgré le nombre réduit de pôles magnétiques ou statoriques.

Avantageusement, le stator est constitué par une pièce unique découpée pour présenter deux paires de circuits en "W" diamétralement opposés dont les extrémités polaires sont équidistantes angulairement. Avantageusement, les jambes recevant les bobines électriques s'étendent dans une partie centrale évidée dont les dimensions permettent l'introduction d'une bobine électrique dans le plan des jambes et la mise en place autour de la jambe correspondante par translation.

Les bobines peuvent être ainsi fabriquées séparément selon des procédés plus économiques que le bobinage autour d'une partie statorique complexes, et être ensuite enfilées sur les jambes correspondantes.

Le stator peut être fabriqué selon des procédés simples et peut coûteux. Le fait qu'il soit formé par une seule pièce découpée évite les problèmes de précision de l'assemblage et de dérèglement.

De préférence, les jambes portant les bobines électriques s'étendent radialement. Selon un mode de réalisation particulier, le stator est constitué par un empilement de tôles fines. Ce mode de réalisation permet d'utiliser des techniques d'usinage peu coûteuses pour la découpe du stator, et d'améliorer les performances magnétiques du stator.

De préférence, l'extrémité frontale de l'épanouissement polaire est située dans le plan de la face frontale intérieur de la bobine.

Selon une variante de réalisation particulière, le rotor est formé par un aimant aimanté suivant une direction perpendiculaire au plan du stator et placés entre deux disques crantés présentant des dents décalées.

Selon une variante particulière de réalisation, le moteur diphasé présente une pièce auxiliaire de fermeture de flux, avantageusement une pièce de fermeture du flux magnétique en un matériau doux coaxial avec le rotor.

Selon un premier mode de réalisation, la pièce de fermeture du flux magnétique est une pièce cylindrique en forme de bague.Cette bague peut être fixe par rapport au rotor, ou solidaire de l'aimant.

Selon un deuxième mode de réalisation, la pièce de fermeture du flux magnétique est une pièce cylindrique en forme de bague présentant des cannelures formant des dents placées en regard des dents statoriques.

L'invention sera mieux comprise à la lecture de la description qui suit, faisant référence aux dessins annexés où :
- les figures 1 et 2 représentent des vues respectivement de dessus et en coupe transversale d'une première variante d'un moteur selon l'invention ;
- la figure 3 représente une vue de dessus d'une deuxième variante du moteur selon l'invention ;
- la figure 4 représente une vue de dessus d'une troisième variante du moteur selon l'invention ;
- la figure 5 représente une vue de dessus d'une quatrième variante du moteur selon l'invention ;
- la figure 6 représente une vue en coupe transversale d'un rotor pour le moteur selon l'invention ;
- la figure 7 représente une vue de dessus dudit rotor ;
- la figure 8 représente une vue en coupe transversale d'une autre variante de rotor.

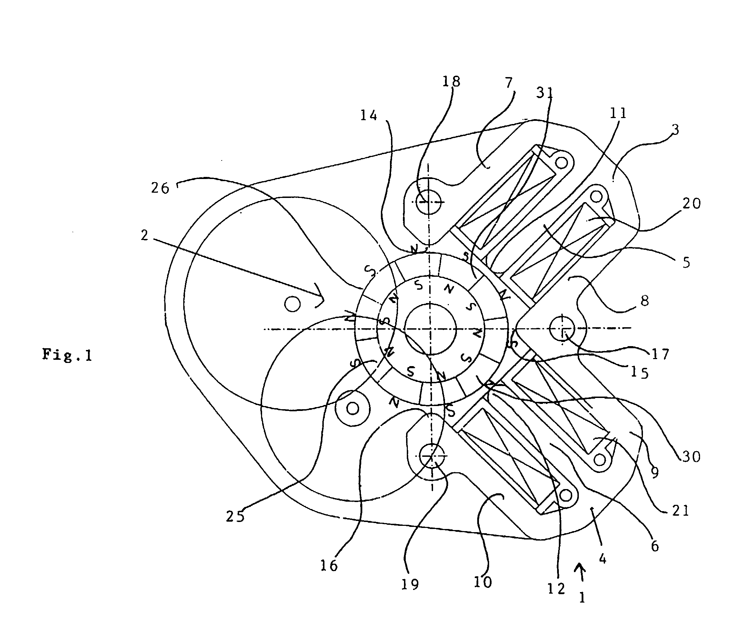

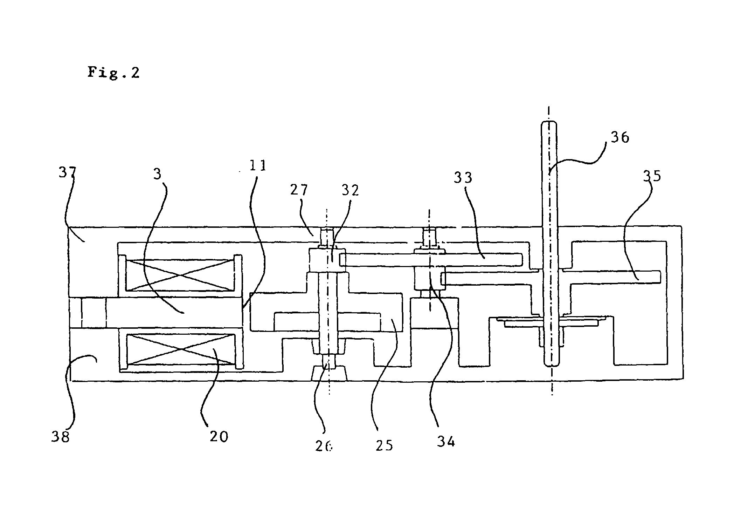

Les figures 1 et 2 représentent des vues respectivement de dessus et en coupe transversale d'un moteur selon l'invention. Le moteur comporte un stator (1) est un rotor (2).

Le stator (1) est réalisé par découpage dans une feuille métallique d'une épaisseur de 2 millimètres, ou par empilement de plusieurs feuilles métalliques en un matériau magnétiquement doux. Le stator présente deux circuits en "W" (3, 4) présentant chacun une jambe médiane (5, 6) et deux jambes latérales (7, 8 et 9, 10). Les jambes médianes (5, 6) se terminent chacune par un épanouissement polaire respectivement (11, 12). Les jambes latérales présentent également des épanouissements polaires (14 à 16), les deux jambes (8, 9) appartenant respectivement au premier circuit en "W" (3) et au second circuit en "W" (4) présentant dans l'exemple de réalisation décrit un épanouissement polaire commun.

Le stator (1) présente par ailleurs des trous (17, 18, 19) pour le passage d'organe de fixation sur un support, par exemple de vis ou des rivets.

Les jambes médianes (5, 6) reçoivent des bobines électriques respectivement (20, 21). Ces deux jambes (5, 6) sont orientées radialement.

Le rotor (2) présente 5 paires de pôles magnétiques. Il est formé par une pièce cylindrique (25) aimantée radialement pour présenter alternativement, à la surface extérieure (26), des pôles SUD et des pôles NORD. La partie aimantée peut être formée par l'association d'aimants minces en forme de tuiles collées sur un noyau cylindrique ou encore par l'aimantation de secteurs tubulaires.

Une autre solution encore consiste à aimanter en surface une pièce cylindrique selon des festons de façon à ce que deux pôles opposés soient formés par des éléments de surface périphérique adjacents, reliés par une zone en arc de cercle pénétrant à l'intérieur de l'élément cylindrique.

Le rotor (2) est supporté de manière connue par des pivots (26, 27) visibles sur la figure 2.

Les jambes médianes (5, 6) des deux phases opposées supportant les bobines électriques (20, 21) sont orientées de manière à ce que, lorsqu'un pôle magnétique (30) est en regard de l'un des épanouissements polaires (12), l'autre épanouissement polaire (11) est en regard d'une transition (31).

Le rotor (2) présente une bague crantée (32) propre à entraîner un train d'engrenage (33 à 35). Ce train d'engrenage transmet le mouvement rotatif à un arbre de sortie (36).

Le stator (1) est logé dans l'exemple décrit dans un boîtier formé de deux coques (37, 38) complémentaires assurant par ailleurs le maintien des axes du train d'engrenage (32 à 35).

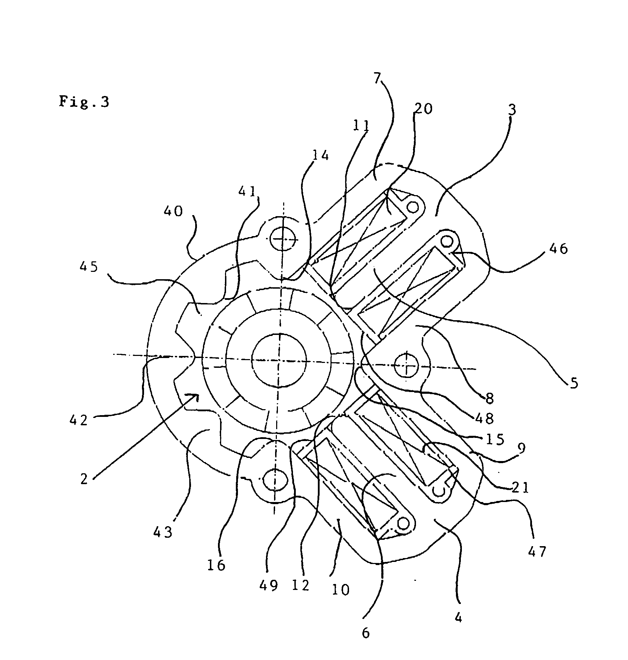

La figure 3 représente une variante de réalisation différente de celle précédemment décrit par le fait que les épanouissements polaires (14, 16) formant les extrémités des jambes extérieures (7, 10) des deux circuits sont réunis par un pontet (40) présentant des dents polaires (41 à 43). L'ensemble formé par les circuits en "W" (3, 4) et par le pontet (40) est découpé dans une seule pièce en un matériau magnétiquement doux, ou dans une pluralité de feuilles qui forment un empilement.

La partie centrale (45) du stator (1) est évidée. L'introduction des bobines électriques (20, 21) s'effectue par un premier déplacement selon une direction perpendiculaire au plan du stator correspondant au plan de la figure 3, puis par déplacement par translation radiale pour faire glisser la bobine autour de l'une des jambes médianes (5, 6). Cette opération est bien sur réalisée avant que le rotor (2) ne soit mis en place. La bobine peut être formée sur un noyau (46, 47) dont la section est complémentaire de celle des jambes (5, 6) et présentant une face frontale (48, 49) venant affleurer l'extrémité de l'épanouissement polaire (11, 12) de la jambe (5, 6) correspondante.

La figure 4 représente une vue de dessus d'une troisième variante de réalisation différent des précédentes variantes par le fait que les circuits en "W" (3, 4) sont séparés. Ils sont positionnés de façon à ce que, lorsque l'épanouissement polaire (11) de la jambe centrale (5) de l'un des circuits en "W" (3) se trouve en face d'une transition magnétique (31), l'épanouissement polaire (12) de la jambe centrale (6) de l'autre circuit en "W" (4) se trouve en face d'un pôle magnétique (50).

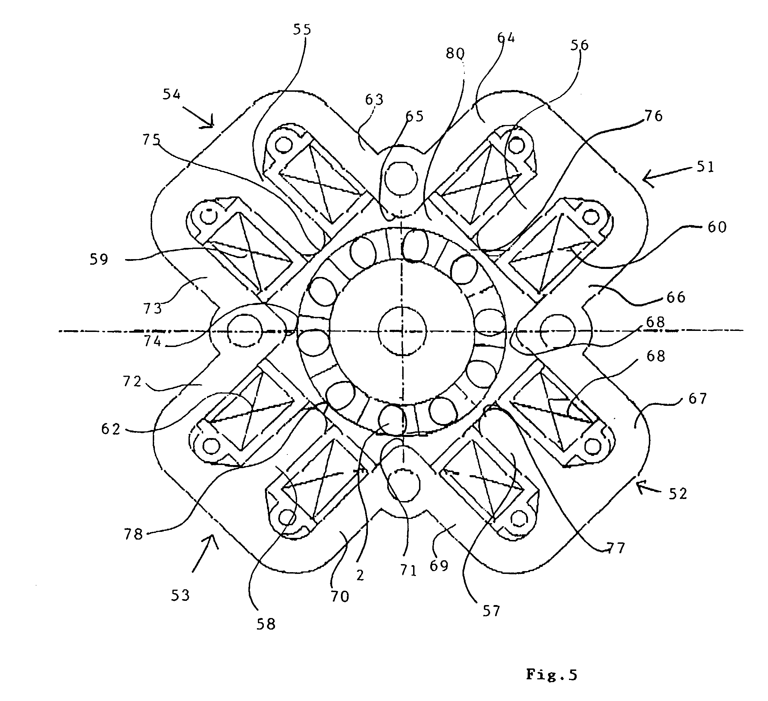

La figure 5 représente une vue de dessus d'une quatrième variante de réalisation différent des précédentes variantes par le fait qu'il comporte quatre circuits en "W" (51, 52, 53, 54). Deux circuits en "W" diamétralement opposés appartiennent à une même phase. Les jambes médianes (55, 56, 57, 58) supportent chacune une bobine électrique (59, 60, 61, 62). Deux jambes latérales consécutives (63, 64), (66, 67), (69, 70), (72, 73) représentent des épanouissements polaires respectivement (65, 68, 71, 74) communs. Les épanouissements polaires consécutifs (65, 68, 71, 74, 75 à 78) sont écartés angulairement de π/4.

Le stator présentant les quatre circuits en "W" (51 à 54) est découpé dans une pièce unique ou dans un empilement de pièces et définit un évidement central (80) dont les dimensions et la forme permet l'enfilement des bobines (59 à 62) sur les jambes médianes (55 à 58).

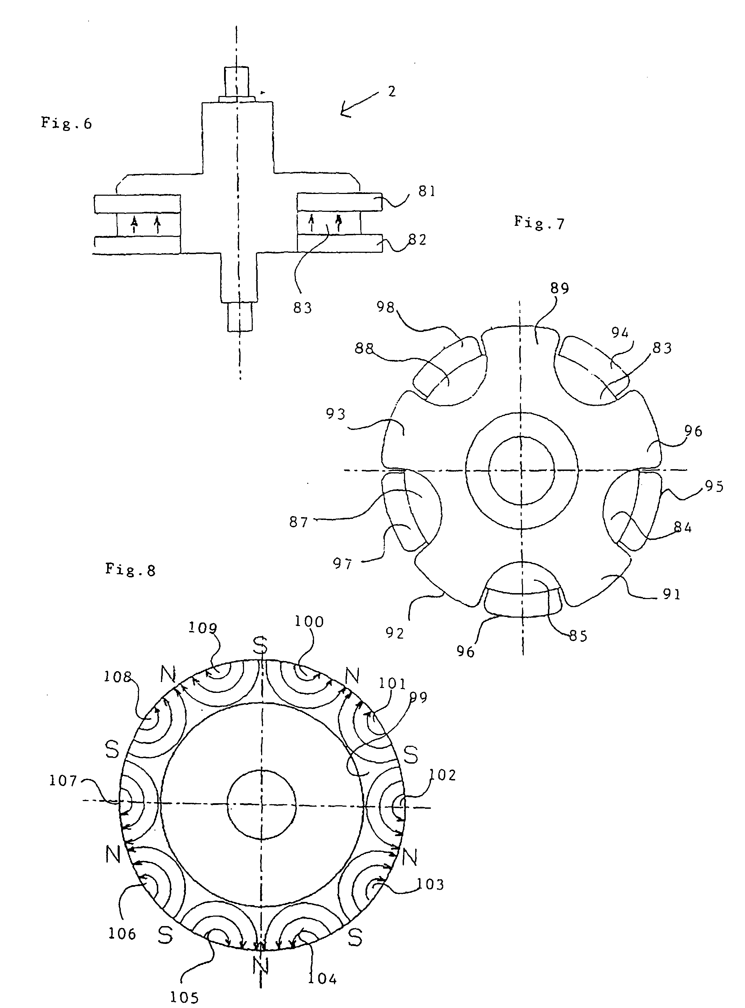

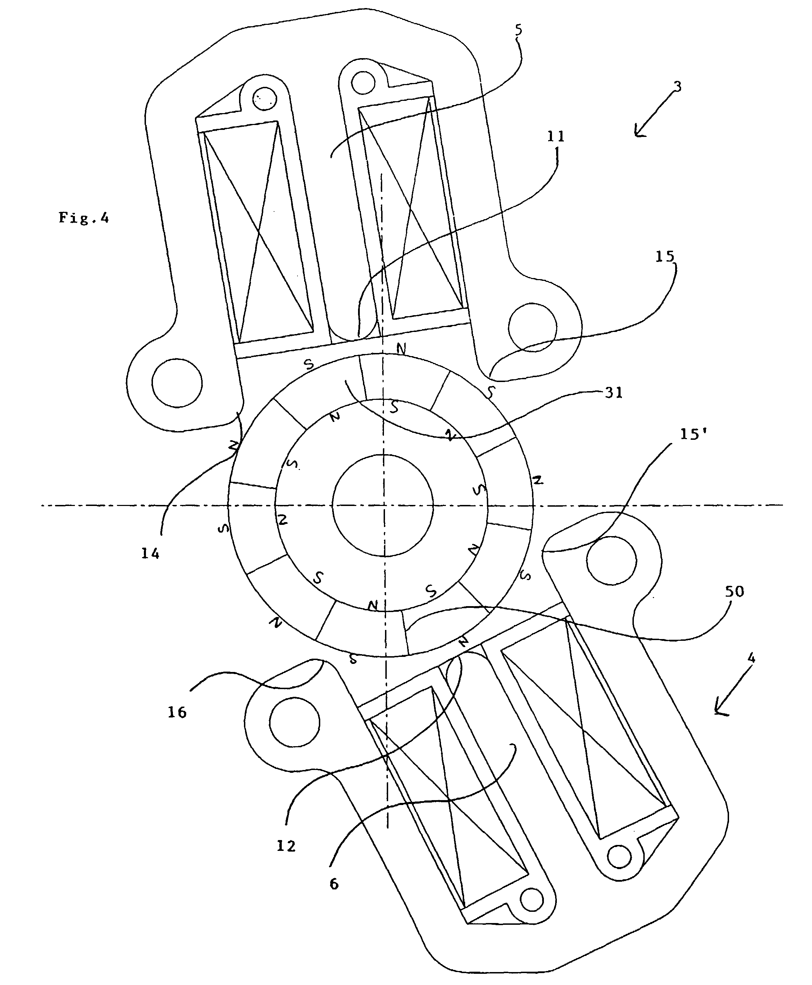

Les figures 6 et 7 représentent des vues respectivement en coupe transversale et de dessus d'un rotor pour le moteur selon l'invention. Le rotor (2) est formé par deux disques crantés présentant des dents décalées (81, 82) entre lesquels est positionné un aimant (83) aimanté suivant une direction perpendiculaire au plan médian du stator. Les dents (89 à 93) de l'un des disques crantés (81) correspondent aux creux formés entre deux dents consécutives (94 à 98) de l'autre disque cranté (82). Chacun des disques crantés (81, 82) présente 5 dents séparées par 5 creux.

La figure 8 une vue en coupe transversale d'une autre variante de rotor. Le rotor comporte une bague (99) en un matériau magnétique doux, présentant dix zones (100 à 109) aimantées en festons de façon à présenter des pôles alternés à la surface de ladite bague (99).

L'invention est décrite dans ce qui précède à titre d'exemples non limitatifs. L'Homme de Métier pourra réaliser différentes formes de stator ou de rotor conforme à l'invention dans le cadre des revendications (ci-apres).

## Revendications

1. Moteur diphasé formé par une partie statorique (1) excitée par des bobines électriques et par un rotor (2) aimanté, le rotor (2) présentant N paires de pôles aimantés radialement en sens alternés, N étant égal à 3 ou à 5, et la partie statorique (1) présentant au moins deux circuits en forme de « w » (3, 4) comportant chacun une bobine électrique (20, 21) entourant la jambe centrale (5, 6), lesdits circuits en « w » (3, 4) étant disposés de façon à ce que lorsque l'une des jambes centrales se trouve en face d'une transition magnetique, l'autre jambe centrale se trouve en face d'un pôle magnétique, caractérisé en ce que les épanouissements polaires des jambes centrales de deux circuits en « w » (3, 4) appartenant à des phases différentes sont écartés angulairement d'un angle sensiblement égal à π/2±k.π/N, où N est le nombre de paires de pôles magnétiques, soit 3 ou 5 et k est égal à 0 , 1, ou 2 et en ce que les épanouissements polaires des jambes d'un circuit en « w » sont espacés angulairement de π/4.

2. Moteur diphasé selon la revendication 1 caractérisé en ce que deux circuits en « w » (3, 4, 51 à 54) présentent un épanouissement polaire commun (15, 65, 68, 71, 74).

3. Moteur diphasé selon la revendication 1 ou 2 caractérisé en ce que les jambes extérieures des deux circuits en « w » (3, 4) sont reliées par un pontet (40) en forme d'arc de cercle.

4. Moteur diphasé selon la revendication 3 caractérisé en ce que le pontet présente des dents statoriques (41, 43) écartées de π/4 degrés.

5. Moteur diphasé selon la revendication 1 caractérisé en ce que le stator est constitué par une pièce unique découpée pour présenter deux paires de circuits en « w » (3, 4) diamétralement opposés dont les épanouissements polaires sont équidistants angulairement avec un pas de π/4.

6. Moteur diphasé selon l'une quelconque des revendications précédentes caractérisé en ce que le stator (1) présente partie centrale évidée dont les dimensions permettent l'introduction d'une bobine électrique dans le plan des jambes et la mise en place autour de la jambe correspondante par translation.

7. Moteur diphasé selon l'une quelconque des revendications précédentes caractérisé en ce que les jambes portant les bobines électriques s'étendent radialement.

8. Moteur diphasé selon l'une quelconque des revendications précédentes caractérisé en ce que le stator est constitué par un empilement de tôles fines.

9. Moteur diphasé selon l'une quelconque des revendications précédentes caractérisé en ce que l'extrémité frontale de l'épanouissement polaire est située dans le plan de la face frontale intérieur de la bobine.

10. Moteur diphasé selon l'une quelconque des revendications précédentes caractérisé en ce le rotor (2) est formé par un aimant aimanté suivant une direction perpendiculaire au plan du stator (1) et placé entre deux disques crantés (81, 82) présentant des dents décalées.

11. Moteur diphasé selon l'une quelconque des revendications 1 à 9 caractérisé en ce le rotor (2) est formé par une bague (99) aimantée en festons.

12. Moteur diphasé selon l'une quelconque des revendications 1 à 10 caractérisé en ce qu'il présente une pièce auxiliaire de fermeture de flux.

13. Moteur diphasé selon la revendication 12 caractérisé en ce que la pièce de fermeture du flux magnétique est une pièce cylindrique en forme de bague présentant des cannelures formant des dents placées en regard des dents statoriques.

## Claims

1. Diphase motor formed of a stator part (1) excited by electric coils and a magnetised rotor (2), rotor (2) having N pairs of poles with radial magnetisation in alternate directions, N being equal to 3 or 5, and the stator part (1) having at least two "w-shaped" circuits (3, 4) each comprising an electric coil (20, 21) surrounding the central limb (5, 6), said "w-shaped" circuits (3, 4) being arranged such that when one of the central limbs comes to be positioned in front of a magnetic transition, the other central limb is positioned in front of a magnetic pole, characterised in that the pole shoes of the central limbs of both "w-shaped" circuits (3, 4) belonging to different phases, are separated by an angular distance by an angle substantially equal to π/2±k.π/N, in which N is the number of pairs of magnetic poles, namely 3 or 5, and k is equal to 0, 1 or 2, and in that the pole shoes of the limbs of one "w-shaped" circuit are distanced by an angle of π/4.

2. Diphase motor according to claim 1, characterised in that two "w-shaped" circuits (3, 4, 51 to 54) have a common pole shoe (15, 65, 68, 71, 74).

3. Diphase motor according to claim 1 or 2, characterised in that the outer limbs of the two "w-shaped" circuits (3, 4) are connected by a connexion member (40) in the form of an arc of a circle.

4. Diphase motor according to claim 3, characterised in that the connexion member has stator teeth (41,43) spaced by π/4 degrees.

5. Diphase motor according to claim 1, characterised in that the stator is made up of a single part cut out to have two pairs of diametrically opposite "w-shaped" circuits (3, 4) whose pole shoes are angularly equidistant with a step of π/4.

6. Diphase motor according to any of the preceding claims, characterised in that the stator (1) has a central cut-out part sized so that an electric coil can be inserted in the plane of the limbs with positioning around the corresponding limb by translation.

7. Diphase motor according to any of the preceding claims characterised in that the limbs carrying the electric coils extend radially.

8. Diphase motor according to any of the preceding claims, characterised in that the stator is made up of a stack of thin sheets.

9. Diphase motor according to any of the preceding claims characterised in that the front end of the polar pole shoe is positioned in the plane of the inner front side of the coil.

10. Diphase motor according to any of the preceding claims, characterised in that the rotor (2) is formed by a magnet magnetised in perpendicular direction to the plane of the stator (1) and placed between two notched disks (81, 82) having staggered teeth.

11. Diphase motor according to any of claims 1 to 9, characterised in that rotor (2) is formed by a ring (99) with scalloped magnetisation.

12. Diphase motor according to any of claims 1 to 10, characterised in that it has a flux-closing auxiliary part.

13. Diphase motor according to claim 12, characterised in that the magnetic flux-closing part is a ring-shaped cylindrical part having ridges forming teeth placed opposite the stator teeth.

## Patentansprüche

1. Zweiphasen-Motor bestehend aus einem von Stromspulen erregten Statorteil (1) und einem magnetisierten Rotor (2), wobei der Rotor (2) N in abwechselnder Richtung radial magnetisierte Polpaare aufweist, wobei N gleich 3 oder 5 entspricht, und wobei das Statorteil (1) mindestens zwei "w-förmige" Kreise (3, 4) mit jeweils einer den mittleren Schenkel (5, 6) umgebenden Stromspule (22, 22) aufweist, wobei die sogenannten "w-förmigen" Kreise (3, 4) so angeordnet sind, dass wenn sich einer der mittleren Schenkel gegenüber einem Magnetübergang befindet, sich der andere mittlere Schenkel gegenüber einem Magnetpol befindet, dadurch gekennzeichnet, dass die Polausbauchungen der mittleren Schenkel zweier "w-förmiger", zu unterschiedlichen Phasen gehörender Kreise (3, 4) winkelförmig um einen Winkel von etwa π/2±k.π/N abgespreizt sind, wo N die Anzahl der Magnetpolpaare, d.h. 3 oder 5, und k gleich 0, 1 oder 2 ist, und dass die Polausbauchungen der Schenkel eines "w-förmigen" Kreises in einem Abstand mit einem Winkel von π/4 angeordnet sind.

2. Zweiphasen-Motor nach Anspruch 1, dadurch gekennzeichnet, dass zwei "w-förmige" Kreise (3, 4, 51 bis 54) eine gemeinsame Polausbauchung (15, 65, 68, 71, 74) aufweisen.

3. Zweiphasen-Motor nach Anspruch 1 oder 2, dadurch gekennzeichnet, dass die externen Schenkel der beiden "w-förmigen" Kreise (3, 4) anhand einer kreisbogenförmigen Brücke (40) verbunden sind.

4. Zweiphasen-Motor nach Anspruch 3, dadurch gekennzeichnet, dass die Brücke in einem Abstand von π/4 Grad zueinander angeordnete Statorzähne (41, 43) aufweist.

5. Zweiphasen-Motor nach Anspruch 1, dadurch gekennzeichnet, dass der Stator aus einem einzigen ausgestanzten Teil mit zwei diametral gegenüberliegenden, "w-förmigen" Kreispaaren (3, 4) besteht, deren Polausbauchungen winkelförmig in gleichem Abstand von π/4 zueinander angeordnet sind.

6. Zweiphasen-Motor nach einem der vorherigen Ansprüche, dadurch gekennzeichnet, dass der Stator (1) einen mittleren Hohlraum aufweist, dessen Abmessungen die Einführung einer Stromspule auf der Schenkelebene und den Einsatz per Verschiebung um den entsprechenden Schenkel herum ermöglichen.

7. Zweiphasen-Motor nach einem der vorherigen Ansprüche, dadurch gekennzeichnet, dass sich die die Stromspulen tragenden Schenkel in radialer Richtung erstrecken.

8. Zweiphasen-Motor nach einem der vorherigen Ansprüche, dadurch gekennzeichnet, dass der Stator aus einem Stapel von dünnen Blechen besteht.

9. Zweiphasen-Motor nach einem der vorherigen Ansprüche, dadurch gekennzeichnet, dass das vordere Ende der Polausbauchung auf Ebene der vorderen Innenseite der Spule angeordnet ist.

10. Zweiphasen-Motor nach einem der vorherigen Ansprüche, dadurch gekennzeichnet, dass der Rotor (2) aus einem nach einer lotrechten Richtung zur Ebene des Stators (1) magnetisierten Magneten besteht und zwischen zwei Zahnscheiben (81, 82) mit versetzten Zähnen angeordnet ist.

11. Zweiphasen-Motor nach einem der Ansprüche 1 bis 9, dadurch gekennzeichnet, dass der Rotor (2) aus einem magnetisierten Rändelring (99) besteht.

12. Zweiphasen-Motor nach einem der Ansprüche 1 bis 10, dadurch gekennzeichnet, dass er ein Hilfsteil zum Verschließen des Flusses aufweist.

13. Zweiphasen-Motor nach Anspruch 12, dadurch gekennzeichnet, dass das Verschlussteil des Magnetflusses ein ringförmiges, zylindrisches Teil mit Rillen ist, die Zähne bilden, die den Statorzähnen gegenübersitzen.
